# EUROPEAN PATENT SPECIFICATION

(11) **EP 2 220 400 B1**
(45) Date of publication and mention of the grant of the patent: **16.05.2012**
(21) Application number: 08856707.8
(22) Date of filing: 04.12.2008
(51) Int. Cl.: F16H 49/00, H01L 41/09

(54) **HARMONIC MOTOR**
OBERWELLENMOTOR
MOTEUR HARMONIQUE

(30) Priority: 05.12.2007 US 996795 P
(43) Date of publication of application: 25.08.2010
(73) Proprietor: ABB Research Ltd., 8050 Zürich (CH)
(72) Inventor: LUNDBERG, Ivan, S-722 46 Västerås (SE); SIRKETT, Daniel, S-72210 Västerås (SE); KOCK, Sönke, S-722 18 Västerås (SE)
(74) Representative: Johansson Webjörn, Ingmari
(86) International application number: PCT/EP2008/066743
(87) International publication number: WO 2009/071604

(56) References cited:
- DE-C1- 19 747 566
- US-A1- 2002 135 241
- US-A1- 2003 038 563
- US-A1- 2005 124 452
- US-A1- 2005 253 675

## Description

### TECHNICAL FILED

The present invention relates to motors that provide rotary motion. A motor comprising a harmonic gear reducer with an integrated, active means for generation of the traveling wave is referred to as a harmonic motor.

### BACKGROUND ART

Electric motors are commonly used as prime motive power for many industrial applications. However, their high speed, low torque characteristics are not ideal for robotics axes in which high torque, low speed characteristics are desirable. This necessitates the use of high reduction gearing. For robotics applications a typical drive solution is to use an electric motor in conjunction with a harmonic drive gear reducer. Through suitable mounting arrangements, it is possible to achieve partial integration of the motor and gear reducer.

A harmonic drive is a gear reduction device that exploits material flexibility in order to achieve a high reduction ratio with minimal backlash. In comparison to conventional multistage spur gear trains of similar reduction ratios, the harmonic drive offers a more compact and lightweight drive of simpler construction which lends itself well to high precision applications such as robotics.

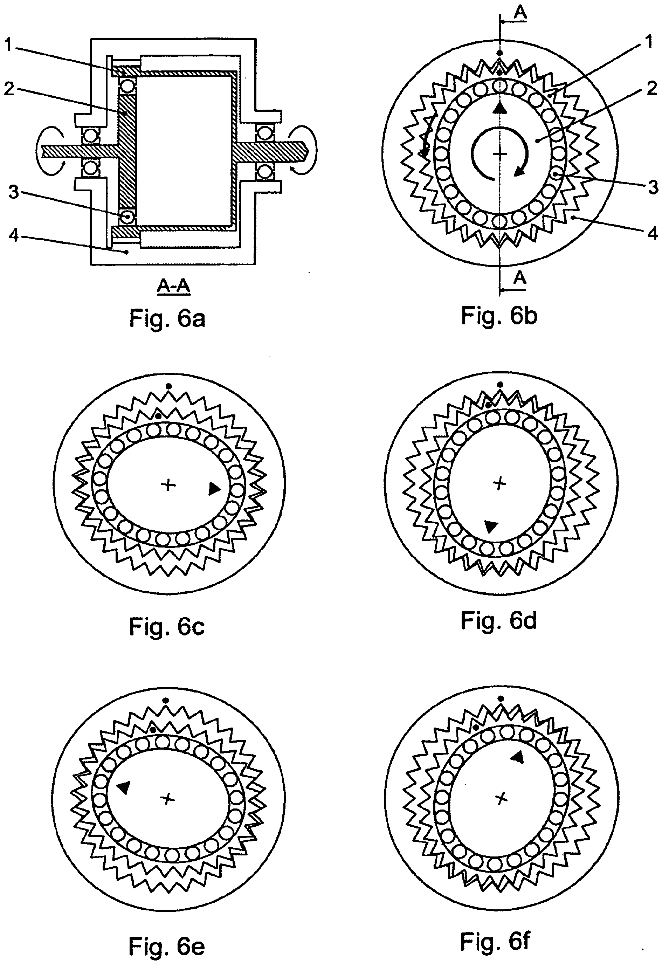

The operating principle of the harmonic drive gear reducer is shown in Figure 6. The three main components in a typical harmonic drive are a flex spline, a circular spline and a wave generator. The input, output and fixed components are interchangeable amongst these components, but in the embodiment shown in Figure 6, the input is the wave generator, the output is the flex spline and the circular spline remains stationary. The flex spline 1 consists of a flexible tube that is closed at one end and upon whose outer surface are cut gear teeth. The wave generator is an elliptical cam 2 around whose periphery is placed a bearing 3. The wave generator locates inside the flex spline, such that the flex spline deforms elastically into an elliptical shape. The flex spline locates inside the circular spline 4, which is a rigid gear having internal teeth. There are 2*n* (where *n* is a positive integer) fewer teeth on the flex spline than on the circular spline. The teeth of the flex spline mesh with those of the circular points at the two lobes at either end of the major axis of the ellipse. Rotary input is applied to the wave generator cam, causing the deformed elliptical shape of the flex spline to rotate. In this manner a "traveling wave" is set up in the flex spline. Due to the disparity in the number of teeth between the two gears, rotation of the flex spline ellipse shape causes the flex spline itself to rotate in the opposite sense to the cam and at a reduced speed. The reduction ratio achievable using this drive is given by the number of teeth on the flex spline divided by 2*n*.

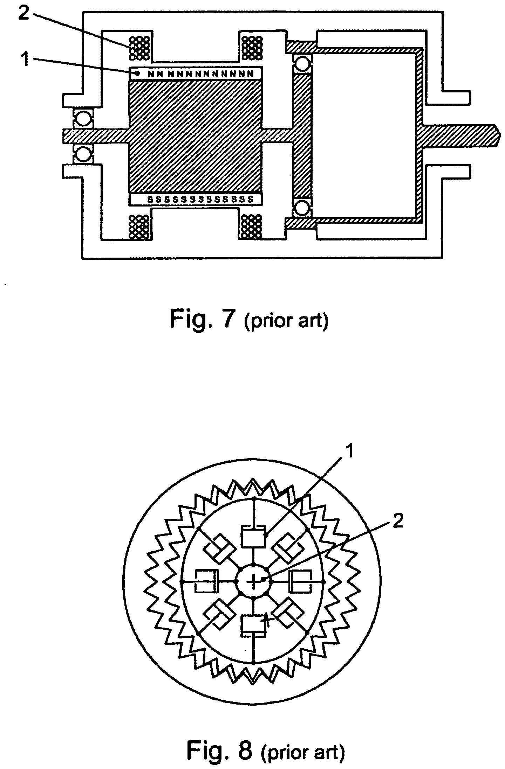

US2002/0135241A1 teaches the use of bearings and housings that are common to both motor and reducer and through combining the motor rotor and elliptical cam into a single machined component (Figure 7). While shared bearings and housings may reduce the complexity of the axis drive, the principle of operation remains the same; rotation of the motor shaft is converted to a traveling wave deformation in the flex spline by way of the wave generator cam. The latter requires precise dimensional tolerances and so machining from solid metal is the preferred method of manufacture. This results in a heavy component with a large diameter, situated on the input side of the gear reducer. Weight savings can be made through the use of alternative materials or through removal of material at strategic locations. However the care required in the execution of such measures is increased by the necessity to maintain uniformity of thermal expansion coefficients across the components of the drive. When combined, the inertia of the wave generator cam and the motor rotor represent a significant energy source/sink which is undesirable in terms of both performance and safety.

US2005253675 teaches a harmonic motor driven using electromagnetic principles, as first suggested in the original CW Musser's original patent US2906143 (Figure 9). The circular flexspline 1 is sandwiched between a stationary circular core 2 and a stationary stator 3. Around the inward facing surface of the stator and the outward facing surface of the core are arranged solenoids 4 wound around radial-aligned teeth. By driving a pair of coils diametrically opposite one another on the core and a second pair of coils 90 degrees offset from these and diametrically opposite one another on the stator, the flex spline is attracted to the core at two regions which represent the extreme of its minor axis, and to the stator at the extreme of its major axis. By sequentially energizing adjacent sets solenoids, the regions of attraction are made to rotate, thereby producing the traveling wave. The flex spline is equipped with inward-facing teeth which mesh with a circular output spline 5 that is located within the flex spline.

JP19900230014 teaches a similar arrangement comprising electrostatic means of actuation. The main advantage of drives operating on electrostatic or electromagnetic actuation principles is that the only moving part is the output shaft itself. Hence stored kinetic energy is greatly reduced.

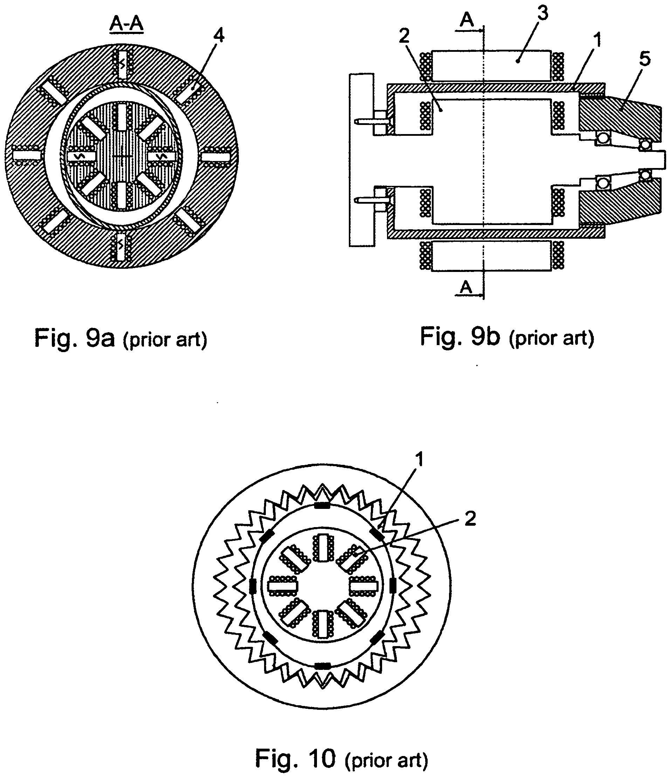

US6664711B2 teaches a harmonic motor using an electromagnetic principle and additionally equips the flex spline with magnets 1 opposite the solenoid cores 2 and exploits repulsion effects instead of attraction (Figure 10).

US7086309B2 teaches an arrangement wherein pneumatic actuators are mounted externally to the flex spline to drive a conventional elliptical wave-generator cam. The document also teaches an arrangement with radial acting pneumatic diaphragm actuators mounted within the flex spline cylindrical void and acting directly on its surface to generate the rotating elliptical shape. The arrangement is as shown in Figure 8 and the actuators are capable of both pushing and pulling the flex spline surface and the elliptical shape is fully constrained at all times, but losses arise due to viscoelastic effects.

Document DE 197 47 566 C1 shows the preamble of claims 1 and 10, and discloses a piezo driven tension wave drive with rigid splined unit and flexible unit having splines and also a wave generator. It teaches a deflection generator (WG) having piezo adjusting elements, which are arranged locally fixed relative to the flexible unit, and which deforms the flexible unit, with length alterations tuned to each other. The piezo stacking actuators (PS) are coupled together in a displacement translation unit (WE). The linear expansion of the stacking actuators are enlarged using a lever arm (HA), rotationally located in such a way that the lever arm deflected by the actuator, deforms the elastic unit. In addition flexible piezo actuators (BP) are provided, which directly deform the flexible unit (FS) to an ellipse.

Thus, there is a need to reduce the manufacturing costs and the weight as well as simplifying the control of a harmonic motor. The prior art motors do not fulfill this need.

### SUMMARY OF THE INVENTION

The aim of the invention is to remedy the above mentioned drawbacks with harmonic motors defined, as mentioned above.

The above problem is according to the first aspect of the invention solved in that a device of the kind in question has the specific features that it comprises a fixed circular and internally geared stator, a flex spline coaxially arranged within the stator where the flex spline comprises both external and internal gears. Further, a geared output shaft is coaxially arranged within the flex spline and the motor further comprises means for sequentially deforming the flex spline into an ellipse shape, internally meshing the output shaft. Further, the number of teeth on the stator equals the external teeth on the flex spline such that the flex spline meshes at two lobes of the ellipse shape and every tooth on the flex spline meshes with the same counterpart tooth on the stator.

The flex spline is stationary and this arrangement prevents rotation of the flex spline relative to the circular stator and the rotary output is taken from the central circular gear. The external flex spline arrangement increases the torque per unit diametric deformation the flex spline, which improves efficiency.

According to a feature of the invention, the means for deforming the flex spline comprises a plurality of actuators internally arranged in the stator means adapted to deform the flex spline directly into the desired shape. Compared with actuation from within the flex spline, external actuation increases the space available for mounting the actuators and is claimed to increase the efficiency of the drive.

According to a feature of the invention, the actuator is a discrete and linear actuator adapted to transfer forces from the actuator acting directly on the flex spline. The plurality of actuators is driven in a predefined sequence to produce a traveling wave. The actuators share a common stationary mounting, internal the fixed stator. The advantage of such a drive is that there are no parts with high inertia rotating at high speed, which reduces the kinetic energy stored in the drive and hence improves both controllability and safety.

The arrangement simplifies both transfer of torque out of the drive and restraint of the flex spline. The actuators can be accessed without disassembling the drive. This enables the actuators to be replaced relatively easily compared with the case of an internal mounting arrangement. External mounting improves the electrical connectivity of the actuators while at the same time allowing space for drive electronics to be mounted locally. Airflow around the actuators is similarly enhanced, which increases heat dissipation. The output shaft can be made hollow to allow passage of cables through the drive.

According to another feature of the invention, the actuator is a linear lightweight polymer, electrostrictive actuator.

Electrostrictive actuators are a class of electroactive polymers that deform under the influence of a high voltage electric field. The deformation is characterized by a reduction in thickness and an increase in area. This effect has been harnessed to create lightweight diaphragm-based actuators capable of high bandwidth linear position control. A commercial implementation of the technology has been created by Artificial Muscle Inc.

Lightweight polymer, electrostrictive actuators are claimed to offer a power to weight ratio up to two orders of magnitude higher than that of electromagnetic devices. This in theory allows the stored kinetic energy to be significantly lower than that of a conventional electric motor and reduction gear drive, which increases inherent safety.

The displacement attainable with electrostrictive actuators is greater than with piezo electric actuators which obviates the requirement for mechanical stroke amplification.

Another advantage of using electrostrictive actuators is that analogue position control is possible. This means that while there are a finite number of actuators, the displaced position of each actuator is, in theory, infinitely adjustable. This enables the rotational position of the ellipse shape, and hence that of the output shaft, to be steplessly controlled. By contrast, linear actuation achieved using electromagnetic principles tends to be characterised by "on-off" behavior, which limits controllability.

Compared with shape memory alloy actuators, electrostrictive actuators offer significantly higher bandwidh, with actuation frequencies of up to 17 kHz reported in the literature (Kombluh, R. et al., 1998).

According to another feature of the invention, the actuator comprises means for transfer force from the actuators to the flex spline. Each transfer means comprises a miniature transfer unit comprising a rolling element e.g. a ball. The use of e.g. a ball to transfer force from the actuators to the flex spline allows deviation in the point of force application to occur without introducing losses due to friction or viscoelastic effects. Further, torsional stiffness of the drive is maintained. In the present design, the flex spline is afforded translational freedom through the use of rolling contact with the actuator.

According to another feature of the invention, the flex spline comprises a groove arranged running around the central portion of the outer surface of the flex spline. The flex spline comprises two portions on the outer surface of the flex spline, flanking either side of the groove, equipped with gear teeth.

The use of external gear teeth on both outer portions of the flex spline applies a restraining torque to both ends of the flex spline. This simplifies the construction and manufacture of the drive as the two halves of the stator are functionally identical.

According to a further feature of the invention, the flex spline is tube shaped. The flex spline is tubular and not cup-shaped, which enables simpler manufacturing processes such as extrusion to be employed. Furthermore, assembly of the drive is simplified.

### BRIEF DESCRIPTION OF THE DRAWINGS

Figure 1 is a harmonic motor according to the invention,
Figure 2 is a radial cross section X-X through the harmonic motor in Figure 1,
Figure 3 is an axial cross section through the harmonic motor in Figure 1,
Figure 4 is a radial cross section Y-Y through the harmonic motor in Figure 1,
Figure 5 is a phased cyclic displacement of the actuators over a single rotation of the ellipse shape,
Figure 6 is an operating principle of the harmonic drive gear reducer,
Figure 7 is an integrated harmonic drive arrangement in which motor rotor and windings share a common housing and bearings with the gear reducer.
Figure 8 is a harmonic motor comprising discrete linear actuators attached to a stationary hub for deforming a flex spline,
Figure 9 is an electromagnetic harmonic motor using magnetic attraction,
Figure 10 is an electromagnetic harmonic motor using magnetic repulsion

### DESCRIPTION OF THE PREFERRED EMBODIMENTS

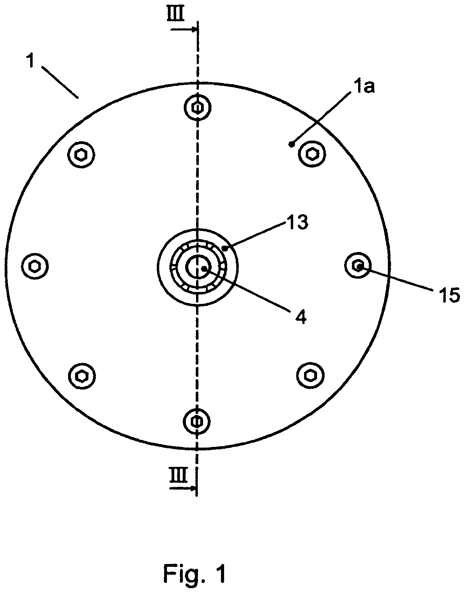

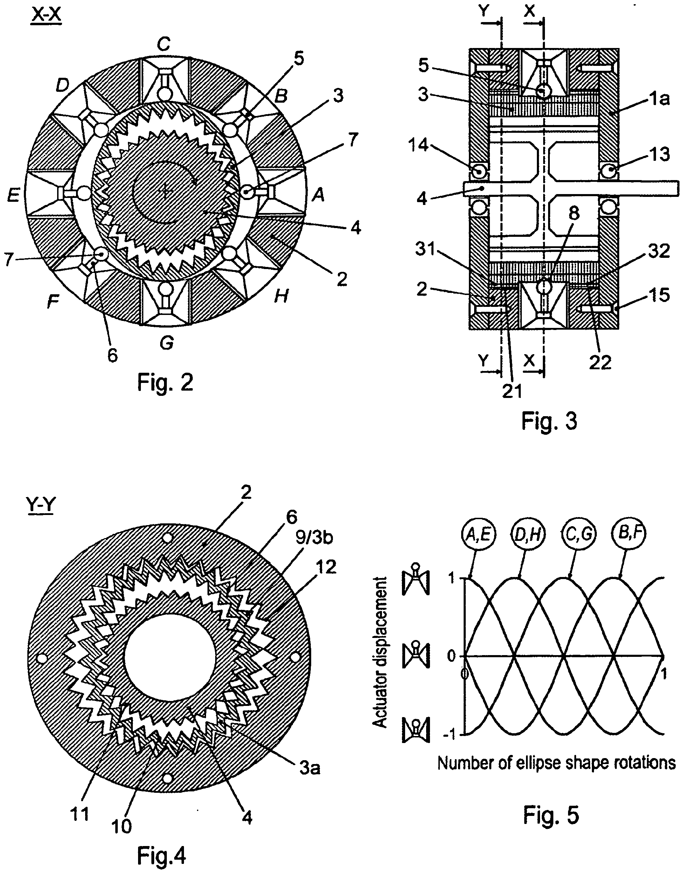

**Figure 1** is a harmonic motor 1 according to the present invention, where the housing 1a comprises fastening means 15 e.g. bolts. The motor comprises a fixed circular stator 2, a flex spline 3 and an output gear 4 (**Figure 2**). The flex spline 3 is arranged coaxially within the stator 2. The output gear 4 is arranged coaxially within the flex spline 3 and supported by two bearings 13, 14 arranged in the housing 1a of the motor at a distance and on either side of the flex spline. Eight linear actuators 5 are mounted radially disposed on the internal surface 2a of the fixed stator 2. Each actuator comprises a means transferring force to the flex spline with an output shaft 6 connected to a ball 7. The ball is the rolling element within a miniature ball transfer unit.

The balls 7 locate in a v-shaped groove 8 arranged running around the central portion of the outer surface of the flex spline 3 (**Figure 3**). The portions 31 and 32 on the outer surface 3b of the flex spline, flanking either side of the groove 8, are equipped with gear teeth 9 (**Figure 4**). The teethed sections 31 and 32 of the flex spline, mesh with gears 12 comprised in the internally teethed sections 21 and 22 of the stator 2.

**Figure 5** illustrates the phased cyclical displacement of the actuators 5 as a function of the angular position of the ellipse. The traveling wave is generated by means of eight actuators, which apply force in a radial direction directly to the external surface 3b of the flex spline by way of the miniature ball transfer units.

The number of teeth in the teethed sections 21, 22 on the stator 2 equals that on the external surface 3b of the flex spline 3, although the diameter of the stator gear is slightly larger, being equal to the locus of the endpoints of the major axis of the rotating ellipse. In this way the flex spline 3 meshes at the two lobes of the ellipse shape and every tooth 31, 32 on the flex spline 3 always meshes with the same counterpart tooth 21, 22 on the stator 2 (**Figure 4**). This arrangement prevents rotation of the flex spline 3 relative to the stator 2 while allowing the point of force application on the flex spline surface to translate, by way of the ball 7 transfer units, relative to the actuators 5. This occurs whenever the ellipse major or minor axes are not orthogonally aligned with a given actuator.

Gear teeth 10 on the inner surface 3a of the flex spline mesh with the gears 11 on the rigid circular output shaft 4 arranged coaxially within the flex spline. There are 2*n* fewer teeth on the output gear 4 than on the inner surface of the flex spline, where *n* is a positive integer. As the shape of the ellipse rotates, the output gear rotates in the same sense, but at a reduced speed. The reduction ratio (output speed/input speed) is given by the number of teeth on the flex spline divided by 2*n*.

## Claims

1. A harmonic motor (1) comprising a fixed and circular stator (2), an output shaft (4), a flex spline (3) and a wave generator wherein the stator comprises internal gears (12), the flex spline is coaxially arranged within the stator (2) and **characterized in that** the flex spline comprises both external (9) and internal gears (10), the output shaft (4) comprises external gears (11) and is coaxially arranged within the flex spline (3), the wave generator comprises means for sequentially deforming the flex spline (3) into an ellipse shape internally meshing the output shaft and externally meshing the stator (2), and the number of teeth on the stator equals the external teeth on the flex spline such that the flex spline meshes at two lobes of the ellipse shape and every tooth on the flex spline meshes with the same counterpart tooth on the stator.

2. A harmonic motor according to claim 1, wherein the deforming means comprises a plurality of actuators (5) adapted to transfer forces from the actuators to the flex spline.

3. A harmonic motor according to claim 2, wherein the actuators (5) are arranged internal in the stator (2).

4. A harmonic motor according to claim 3, wherein the actuator (5) is a lightweight polymer, electrostrictive actuator.

5. A harmonic motor according to claim 2, wherein the deforming means comprises a miniature transfer unit with a rolling element (7).

6. A harmonic motor according to claim 5, wherein the rolling (7) element is a ball.

7. A harmonic motor according to any preceding claim, wherein the flex spline (3) is tube shaped.

8. A harmonic motor according to claim 7, wherein the flex spline comprises a groove (8) arranged running around the central portion of the outer surface (3b) of the flex spline.

9. A harmonic motor according to a claim 8, wherein the flex spline comprises two portions (31) and (32) equipped with gear teeth (9) on the outer surface (3b), flanking either side of the groove (8).

10. A method of operating a harmonic motor (1) comprising a fixed circular and internally geared stator (2), a flex spline coaxially arranged within the stator (2) **characterized in that** the flex spline (3) comprises both external (9) and internal gears (10), and a geared output shaft (4) coaxially arranged within the flex spline (3), the method comprising activating means for sequentially deforming the flex spline (3) into an ellipse shape internally meshing the output shaft (4) and externally meshing the stator such the regions of meshing are made to rotate, thereby producing a traveling wave rotating the geared output shaft (4).

11. A method according to claim 10, comprising actuating the actuator (5) under the influence of high voltage electric field.

12. A method according to claim 10 or 11, comprising deforming the flex spline (3) under the influence of a force acting in a radial direction directly to external surface (3b).

13. A method according to any of claims 10-12, comprising controlling the actuators continuously.

## Patentansprüche

1. Harmonic Motor (1) umfassend einen fixen und kreisförmigen Stator (2), eine Ausgangsachse (4), einen Flexspline (3) und einen Wave Generator, wobei der Stator eine Innenverzahnung (12) umfasst und der Flexspline koaxial innerhalb des Stators (2) angeordnet ist, **dadurch gekennzeichnet, dass** der Flexspline sowohl eine Außen- (9) als auch eine Innenverzahnung (10) umfasst, die Ausgangsachse (4) eine Außenverzahnung (11) umfasst und koaxial innerhalb des Flexsplines (3) angeordnet ist, der Wave Generator ein Mittel umfasst zum sequentiellen Verformen des Flexsplines (3) in eine Ellipsenform, die nach innen in die Ausgangsachse eingreift und nach außen in den Stator (2) eingreift, und dass die Zahl der Zähne auf dem Stator gleich den äußeren Zähnen auf dem Flexspline ist, so dass der Flexspline bei zwei Exzentrizitäten der Ellipsenform eingreift und jeder Zahn auf dem Flexspline mit demselben Gegenzahn auf dem Stator eingreift.

2. Harmonic Motor nach Anspruch 1, wobei das Verformungsmittel eine Vielzahl von Aktoren (5) umfasst, die eingerichtet sind, Kräfte von den Aktoren zu dem Flexspline zu übertragen.

3. Harmonic Motor nach Anspruch 2, wobei die Aktoren (5) innerhalb in dem Stator (2) angeordnet sind.

4. Harmonic Motor nach Anspruch 3, wobei der Aktor (5) ein elektrostriktiver, leichter Kunststoff-Aktor ist.

5. Harmonic Motor nach Anspruch 2, wobei das Verformungsmittel eine Miniaturübertragungseinheit mit einem Rollelement (7) umfasst.

6. Harmonic Motor nach Anspruch 5, wobei das Rollelement (7) ein Ball ist.

7. Harmonic Motor nach einem der vorhergehenden Ansprüche, wobei der Flexspline röhrenförmig ist.

8. Harmonic Motor nach Anspruch 7, wobei der Flexspline eine Rille (8) umfasst, die um den Zentralteil der äußeren Oberfläche (3b) des Flexsplines herumlaufend angeordnet ist.

9. Harmonic Motor nach Anspruch 8, wobei der Flexspline zwei Teile (31, 32) umfasst, die mit Getriebezähnen (9) auf der äußeren Oberfläche (3b) ausgerüstet sind und beide Seiten der Rille (8) flankieren.

10. Verfahren zum Betreiben eines Harmonic Motors (1), welcher einen fixen, kreisförmigen und innen verzahnten Stator (2) und einen innerhalb des Stators (2) koaxial angeordneten Flexspline umfasst, **dadurch gekennzeichnet, dass** der Flexspline sowohl eine Außen- (9) als auch eine Innenverzahnung (10) umfasst und eine verzahnte Ausgangsachse (4) koaxial innerhalb des Flexsplines (3) angeordnet ist, wobei das Verfahren ein Aktivierungsmittel umfasst zum sequentiellen Verformen des Flexsplines (3) in eine Ellipsenform, die nach innen in die Ausgangsachse (4) eingreift und nach außen in den Stator eingreift, so dass die Bereiche des Eingriffs zur Rotation veranlasst werden, wodurch eine Wanderwelle erzeugt wird, die die gezahnte Ausgangsachse (4) dreht.

11. Verfahren nach Anspruch 10, welches ein Betätigen eines Aktors (5) unter dem Einfluss eines elektrischen Hochspannungsfelds umfasst.

12. Verfahren nach Anspruch 10 oder 11, welches ein Verformen des Flexsplines (3) unter dem Einfluss einer Kraft umfasst, die in radialer Richtung direkt auf eine äußere Oberfläche (3b) einwirkt.

13. Verfahren nach einem der Ansprüche 10-12, welches ein kontinuierliches Regeln der Aktoren umfasst.

## Revendications

1. Moteur harmonique (1) comprenant un stator fixe et circulaire (2), un arbre de sortie (4), une couronne flexible (3) et un générateur d'ondes, dans lequel le stator comprend un engrenage intérieur (12), la couronne flexible est disposée de façon coaxiale à l'intérieur du stator (2) et **caractérisé en ce que** la couronne flexible comprend à la fois un engrenage extérieur (9) et un engrenage intérieur (10), l'arbre de sortie (4) comprend un engrenage extérieur (11) et est disposé de façon coaxiale à l'intérieur de la couronne flexible (3), le générateur d'ondes comprend un moyen permettant de déformer en séquence la couronne flexible (3) pour lui donner une forme d'ellipse engrenant intérieurement avec l'arbre de sortie et engrenant extérieurement avec le stator (2), et le nombre de dents présentes sur le stator est égal au nombre de dents extérieures de la couronne flexible, de sorte que la couronne flexible engrène au niveau de deux lobes de la forme d'ellipse et que chaque dent de la couronne flexible engrène avec la même dent équivalente du stator.

2. Moteur harmonique selon la revendication 1, dans lequel le moyen de déformation comprend une pluralité d'actionneurs (5) adaptés pour transférer des forces des actionneurs à la couronne flexible.

3. Moteur harmonique selon la revendication 2, dans lequel les actionneurs (5) sont placés à l'intérieur du stator (2).

4. Moteur harmonique selon la revendication 3, dans lequel l'actionneur (5) est un actionneur électrostrictif en polymère léger.

5. Moteur harmonique selon la revendication 2, dans lequel le moyen de déformation comprend une unité de transfert miniature pourvue d'un élément roulant (7).

6. Moteur harmonique selon la revendication 5, dans lequel l'élément roulant (7) est une bille.

7. Moteur harmonique selon l'une quelconque des revendications précédentes, dans lequel la couronne flexible (3) est en forme de tube.

8. Moteur harmonique selon la revendication 7, dans lequel la couronne flexible comprend une rainure (8) formée autour de la partie centrale de la surface extérieure (3b) de la couronne flexible.

9. Moteur harmonique selon la revendication 8, dans lequel la couronne flexible comprend deux parties (31) et (32) équipées de dents d'engrenage (9) sur la surface extérieure (3b), de part et d'autre de la rainure (8).

10. Procédé de mise en oeuvre d'un moteur harmonique (1) comprenant un stator fixe circulaire et à engrenage intérieur (2), une couronne flexible disposée de façon coaxiale à l'intérieur du stator (2), **caractérisé en ce que** la couronne flexible (3) comprend à la fois un engrenage extérieur (9) et un engrenage intérieur (10), et un arbre de sortie à engrenage (4) disposé de façon coaxiale dans la couronne flexible (3), le procédé comprenant l'activation d'un moyen permettant de déformer en séquence la couronne flexible (3) pour lui donner une forme d'ellipse engrenant intérieurement avec l'arbre de sortie (4) et engrenant extérieurement avec le stator de telle manière que les régions d'engrènement sont mises en rotation, produisant de ce fait une onde progressive qui met en rotation l'arbre de sortie à engrenage (4).

11. Procédé selon la revendication 10, comprenant l'actionnement de l'actionneur (5) sous l'influence d'un champ électrique à haute tension.

12. Procédé selon la revendication 10 ou 11, comprenant la déformation de la couronne flexible (3) sous l'influence d'une force agissant dans une direction radiale directement sur la surface extérieure (3b).

13. Procédé selon l'une quelconque des revendications 10 à 12, comprenant le fait de commander les actionneurs de façon continue.
